# EUROPEAN PATENT APPLICATION

(11) **EP 4 507 195 A1**
(43) Date of publication of application: **12.02.2025**
(21) Application number: 23784063.2
(22) Date of filing: 06.01.2023
(51) Int. Cl.: H03H 9/25

(54) **SURFACE ACOUSTIC WAVE RESONATOR AND SURFACE ACOUSTIC WAVE FILTER**

(30) Priority: 08.04.2022 CN 202210367887
(71) Applicant: Zhejiang Starshine Semiconductor Co., Ltd., City Wenzhou, Zhejiang 325024 (CN)
(72) Inventor: LIU, Xiandong, Wenzhou, Zhejiang 325024 (CN); GAO, Anming, Wenzhou, Zhejiang 325024 (CN); JIANG, Wei, Wenzhou, Zhejiang 325024 (CN); ZHANG, Haili, Wenzhou, Zhejiang 325024 (CN)
(74) Representative: Detken, Andreas
(86) International application number: PCT/CN2023/070901
(87) International publication number: WO 2023/193499

(57) **Abstract**

The present application provides a surface acoustic wave resonator and a surface acoustic wave filter. The surface acoustic wave resonator comprises interdigital electrodes; each interdigital electrode comprises a first bus bar and a second bus bar which are oppositely arranged; the first bus bar is connected with a plurality of first fingers and a plurality of second false fingers which are alternately arranged in a first direction; the second bus bar is connected with a plurality of first false fingers and a plurality of second fingers which are alternately arranged in the first direction; the plurality of first fingers are in one-to-one correspondence with the plurality of first false fingers; the plurality of second fingers are in one-to-one correspondence with the plurality of second false fingers; in any two adjacent first and second fingers, a spacing between the end of the first finger away from the first bus bar and the end of the second finger away from the second bus bar is a finger aperture, a plurality of adjacent first and second fingers form a plurality of finger apertures, and at least some finger apertures in the plurality of finger apertures are different. According to the surface acoustic wave resonator, a transverse resonant mode can be reduced, and the effect of suppressing the transverse resonant mode is achieved.

## Description

The present application claims priority to Chinese patent Application No. 202210367887.2, titled "SURFACE ACOUSTIC WAVE RESONATOR AND SURFACE ACOUSTIC WAVE FILTER", filed on April 8, 2022 with the China National Intellectual Property Administration, which is incorporated herein by reference in its entirety.

### FIELD

The present disclosure relates to the technical field of surface acoustic wave filters, and in particular to a surface acoustic wave resonator and a surface acoustic wave filter.

### BACKGROUND

A surface acoustic wave filter is a passive bandpass filter that applies the piezoelectric effect and physical properties of propagating surface acoustic waves. The surface acoustic wave filters are utilized for filtering and delaying electrical signal and are advantageous in, for example, small sizes, stable performances, high overload capacity, small phase distortion, and no need for adjustment. Hence, the surface acoustic wave filters are widely applied to fields such as televisions, video recorders, wireless data transmission systems.

The surface acoustic wave filter comprises a supporting substrate, a temperature compensation layer, and a piezoelectric substrate, which are sequentially stacked, and further comprises a surface acoustic wave resonator arranged on the piezoelectric substrate. The surface acoustic wave resonator operates substantially on a basis of a following process. An electrical signal is inputted into the surface acoustic wave resonator. Due to piezoelectricity of the piezoelectric substrate, the input electrical signal is converted into acoustic waves and then converted back to another electrical signal in the surface acoustic wave resonator. Thereby, undesired signals and noise are removed, and a quality of a received signal is improved. In related art, the temperature compensation layer is usually deposited under the piezoelectric substrate, and a temperature coefficient of the temperature compensation layer is an opposite of that of the piezoelectric substrate, such that a temperature coefficient of the surface acoustic wave resonator is reduced. The piezoelectric substrate needs to be thinned for a better temperature compensation effect on the surface acoustic wave resonator.

A transverse resonance mode may be generated in the surface acoustic wave resonator when a thickness of the piezoelectric substrate is close to a wavelength λ of the acoustic wave propagating in the surface acoustic wave resonator (that is, the thickness of the piezoelectric substrate is less than 10λ). The transverse resonance would introduce sharp transmission zeros in a passband of the surface acoustic wave filter, thereby reducing performances of the surface acoustic wave filter.

### SUMMARY

A surface acoustic wave resonator and a surface acoustic wave filter are provided according to embodiments of the present disclosure. Addressed is a technical issue that a transverse resonance mode may be generated in surface acoustic wave resonators.

Following technical solutions are provided in embodiments of the present disclosure and address the above technical issue.

A surface acoustic wave resonator is provided according to an embodiment of the present disclosure. The surface acoustic wave resonator comprises an interdigital electrode, where: the interdigital electrode comprises a first bus bar and a second bus bar that are opposite to each other, the first bus bar connects multiple first fingers and multiple second pseudo-fingers, which are alternately arranged along a first direction, and the second bus bar connects multiple first pseudo-fingers and multiple second fingers, which are alternately arranged along the first direction.

The multiple first fingers are in one-to-one correspondence with the multiple first pseudo-fingers. For each of the multiple first fingers, a straight line along which said first finger extends is identical to a straight line along which a first pseudo-finger of the multiple first pseudo-fingers which corresponds to said first finger extends, and said first finger and the first pseudo-finger are spaced apart by a first gap.

The multiple second fingers are in one-to-one correspondence with the multiple second pseudo-fingers. For each of the multiple second fingers, a straight line along which said second finger extends is identical to a straight line along which a second pseudo-finger of the multiple second pseudo-fingers which corresponds to said second finger extends, and said second finger and the second pseudo-finger are spaced apart by a second gap.

For every pair of a first finger of the multiple first fingers and a second finger of the multiple second fingers, which are adjacent to each other, a distance between an end of the first finger away from the first bus bar and an end of the second finger away from the second bus bar serves as a respective one of multiple interdigital apertures. The multiple interdigital apertures are formed among the multiple first fingers and the multiple second fingers. At least a part of the multiple interdigital apertures comprises different interdigital apertures.

Herein the surface acoustic wave resonator is provided according to embodiments of the present disclosure. At least a part of the multiple interdigital apertures in the interdigital electrode is altered to form the different interdigital apertures, and the different interdigital apertures can reduce the transverse resonance modes in the surface acoustic wave resonator. Hence, the surface acoustic wave resonator is capable of suppressing the transverse resonance modes.

In an embodiment, the first direction is perpendicular to a lengthwise direction of the multiple first fingers. Along the first direction, the multiple interdigital apertures formed among the multiple first fingers and the multiple second fingers that are alternately arranged are subject to an increase and then a decrease, or subject to one or more increases and one or more decreases that are interleaved.

In an embodiment, at least one of the first bus bar and the second bus bar has a shape of n-th fractal iteration, where the n-th fractal iteration comprises 2ⁿ⁻¹ similar figures of a first fractal iteration that are sequentially connected, and n is a positive integer.

Each of the similar figures of the first fractal iteration comprises a first connecting bar and a second connecting bar that are connected to each other, where a line connecting an end of the first connecting bar away from the second connecting bar and an end of the second connecting bar away from the first connecting bar is located between the first bus bar and the second bus bar.

An acute angle between the first connecting bar and a first straight line serves as a first deflection angle, an acute angle between the second connecting bar and the first straight line serves as a second deflection angle, and the first straight line is perpendicular to the lengthwise direction of the multiple first fingers.

At least a part of the 2ⁿ⁻¹ first deflection angles of the 2ⁿ⁻¹ similar figures of the first fractal iterations ranges from 2° to 16°, and at least a part of the 2ⁿ⁻¹ second deflection angles of the 2ⁿ⁻¹ similar figures of the first fractal iterations ranges from 2° to 16°°.

In an embodiment, one of the first bus bar and the second bus bar has the shape of the n-th fractal iteration, and another of the first bus bar and the second bus bar is a straight bar.

In an embodiment, the first bus bar has the shape of the n-th fractal iteration, and the second bus bar is the straight bar.

The surface acoustic wave resonator comprises another interdigital electrode identical to the interdigital electrode in structure, where the another interdigital electrode and the interdigital electrode share the second bus bar, and the first bus bar of the interdigital electrode and the first bus bar of the another interdigital electrode are located at two sides, respectively, of the second bus bar.

In an embodiment, each of the first bus bar and the second bus bar has the shape of the n-th fractal iteration, where the first bus bar and the second bus bar are symmetrical with respect to a first center line, and the first center line is perpendicular to the lengthwise direction of the multiple first fingers and passes a center of the interdigital electrode.

In an embodiment, each of the first bus bar and the second bus bar has the shape of the n-th fractal iteration, and multiple connecting bars of the first bus bar are parallel to multiple connecting bars, respectively, of the second bus bar.

In an embodiment, a length of the first pseudo-finger corresponding to each first finger is identical, and lengths of first fingers in at least a part of the multiple first fingers are different.

A length of the second pseudo-finger corresponding to each second finger is identical, and lengths of second fingers in at least a part of the multiple second fingers are different.

In an embodiment, the surface acoustic wave resonator further comprises two reflective gratings, which are arranged at two sides, respectively, of the interdigital electrode along a direction perpendicular to the lengthwise direction of the multiple first fingers. Each of the two reflective gratings is spaced apart from the interdigital electrode, and the two reflective gratings are configured to reflect acoustic wave signals, which are leaked into the two sides of the interdigital electrode, back to the interdigital electrode.

In an embodiment, the surface acoustic wave resonator comprises multiple interdigital electrodes, which comprise the interdigital electrode and one or more other interdigital electrodes, each of which is identical to the interdigital electrode in structure. The interdigital electrode and the one or more other interdigital electrodes are sequentially arranged along the direction perpendicular to the lengthwise direction of the multiple first fingers. The two reflective gratings are arranged at two sides, respectively, of the multiple interdigital electrodes along the direction perpendicular to the lengthwise direction of the multiple first fingers. Each of the two reflective gratings is spaced apart from the multiple interdigital electrodes.

A surface acoustic wave filter is further provided according to an embodiment of the present disclosure. The surface acoustic wave filter comprises: a supporting substrate, a temperature compensation layer, and a piezoelectric substrate, which are stacked in the above-listed sequence; and any foregoing surface acoustic wave resonator, which is disposed on the piezoelectric substrate.

A beneficial effect of the surface acoustic wave filter is identical to that of any foregoing surface acoustic wave resonator and is not further illustrated here.

Hereinabove a technical issue addressed by embodiments of the present disclosure, technical features of technical solutions of the present disclosure, and a beneficial effect achieved by the technical features are illustrated. Other technical problems technical issues addressed by the surface acoustic wave resonator and the surface acoustic wave filter according to embodiments of the present disclosure, other technical features of technical solutions of the present disclosure, and a beneficial effect achieved by these technical features would be further illustrated in detail in detailed embodiments.

### BRIEF DESCRIPTION OF THE DRAWINGS

Hereinafter drawings to be applied in embodiments of the present disclosure or in conventional technology are briefly described, in order to clarify illustration of technical solutions according to embodiments of the present disclosure or in conventional technology. Apparently, the drawings in the following descriptions are only some embodiments of the present disclosure. The drawings and textual description are not intended for limiting a scope of concepts of the present disclosure in any manner, but for illustrating the concepts to those skilled in the art through reference to certain embodiments. Other drawings may be obtained by those skilled in the art based on the provided drawings without exerting creative efforts.
FIG. 1 is a schematic diagram of several structures of a first bus bar and a second bus bar of a surface acoustic wave resonator according to an embodiment of the present disclosure.
FIG. 2 is a schematic structural diagram of a surface acoustic wave resonator according to an embodiment of the present disclosure.
FIG. 3 is a graph for comparing test results of a surface acoustic wave resonator as shown in FIG. 2 and a surface acoustic wave resonator in which the transverse resonance mode is not suppressed.
FIG. 4 is a schematic structural diagram of a surface acoustic wave resonator according to another embodiment of the present disclosure.
FIG. 5 is a graph for comparing test results of a surface acoustic wave resonator as shown in FIG. 4 and a surface acoustic wave resonator in which the transverse resonance mode is not suppressed.
FIG. 6 is a schematic structural diagram of a surface acoustic wave resonator according to another embodiment of the present disclosure.
FIG. 7 is a graph for comparing test results of a surface acoustic wave resonator as shown in FIG. 6 and a surface acoustic wave resonator in which the transverse resonance mode is not suppressed.
FIG. 8 is a schematic structural diagram of a surface acoustic wave resonator according to another embodiment of the present disclosure.
FIG. 9 is a schematic structural diagram of a surface acoustic wave resonator comprising two cascaded interdigital electrodes according to an embodiment of the present disclosure.
FIG. 10 is a schematic structural diagram of a surface acoustic wave resonator comprising two cascaded interdigital electrodes according to another embodiment of the present disclosure.
FIG. 11 is a schematic structural diagram of a surface acoustic wave resonator comprising two sequentially connected interdigital electrodes according to an embodiment of the present disclosure.
FIG. 12 is a schematic structural diagram of a surface acoustic wave resonator according to another embodiment of the present disclosure.
FIG. 13 is a schematic structural diagram of a surface acoustic wave resonator comprising two cascaded interdigital electrodes according to another embodiment of the present disclosure.

**Reference signs:**

| | | | |
|---|---|---|---|
| 100: | interdigital electrode, | 110: | first bus bar, |
| 120: | second bus bar, | 111: | first finger, |
| 112: | second pseudo-finger, | 113: | structure of 1^{st} fractal iteration, |
| 114: | structure of 2^{nd} fractal iteration, | | |
| 115. | structure of 3^{rd} fractal iteration, | | |
| 1131, | first connecting bar, | 1132, | second connecting bar, |
| 1133, | first straight line, | 121, | first pseudo-finger, |
| 122, | second finger, and | 200. | reflective grating. |

Explicit embodiments of the present disclosure have been illustrated in the drawings and hereinafter would be further described in detail. The drawings and textual description are not intended for limiting a scope of concepts of the present disclosure in any manner, but for illustrating the concepts to those skilled in the art through reference to certain embodiments.

### DETAILED DESCRIPTION OF EMBODIMENTS

In related art, a temperature compensation layer is usually deposited under a piezoelectric substrate, and a temperature coefficient of the temperature compensation layer is an opposite of that of the piezoelectric substrate, such that a temperature coefficient of a surface acoustic wave resonator is reduced. The piezoelectric substrate needs to be thinned for a better temperature compensation effect on the surface acoustic wave resonator. More complex acoustic wave modes may be excited in the surface acoustic wave resonator when a thickness of the piezoelectric substrate is close to a wavelength λ of the acoustic wave propagating in the surface acoustic wave resonator (that is, the thickness of the piezoelectric substrate is less than 10λ). In such case, a propagation direction of the acoustic waves in the surface acoustic wave resonator deviates from an arrangement direction of finger electrodes in the surface acoustic wave resonator by a large angle. That is, the acoustic waves no longer propagate solely along the arrangement direction of the finger electrodes, and a transverse component is generated. The transverse component would generate a transverse resonance mode when not interfered. The transverse resonance mode introduces significant amplitude between resonance peaks and anti-resonance peaks of the surface acoustic wave resonator. The transverse resonance mode in proximity of the resonance and anti-resonance peaks may cause sharp transmission zeros in a passband of the surface acoustic wave filter, which reduces performances of the surface acoustic wave filter.

In embodiments of the present disclosure, at least a part of multiple interdigital apertures in the interdigital electrode is altered to form different interdigital apertures, and the different interdigital apertures can reduce the transverse resonance modes in the surface acoustic wave resonator. Hence, the surface acoustic wave resonator is capable of suppressing the transverse resonance modes.

The described embodiments are only some rather than all of the embodiments of the present disclosure. Any other embodiments obtained based on the embodiments of the present disclosure by those skilled in the art without any creative effort fall within the scope of protection of the present disclosure.

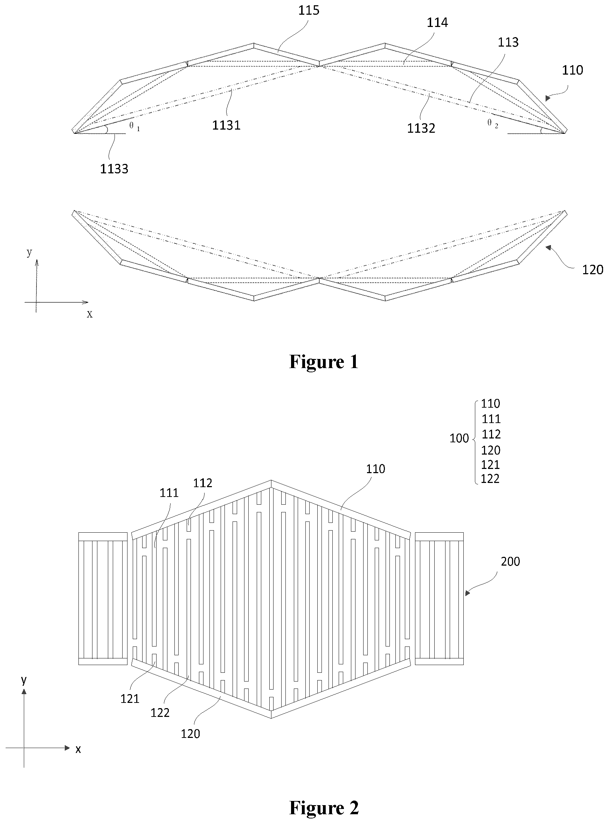

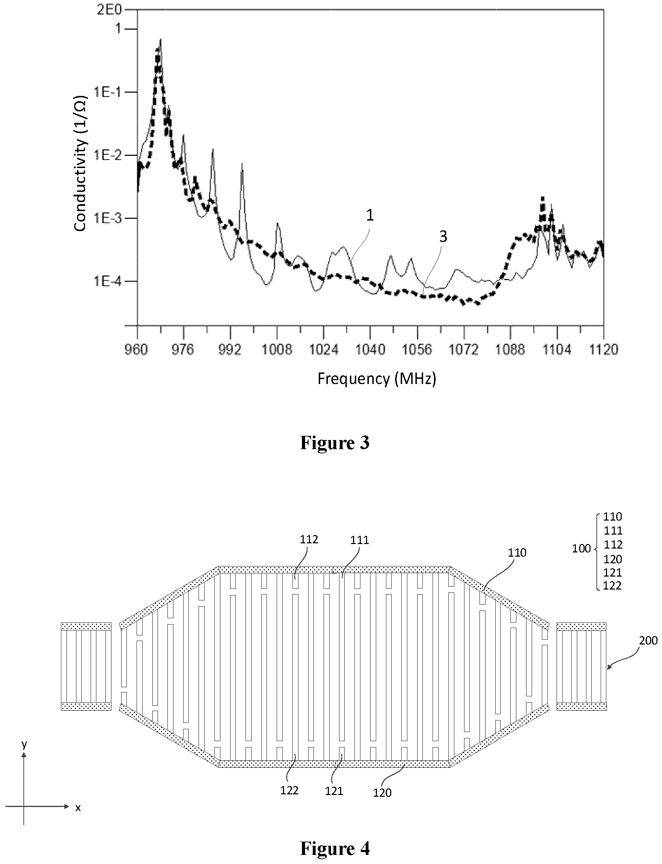

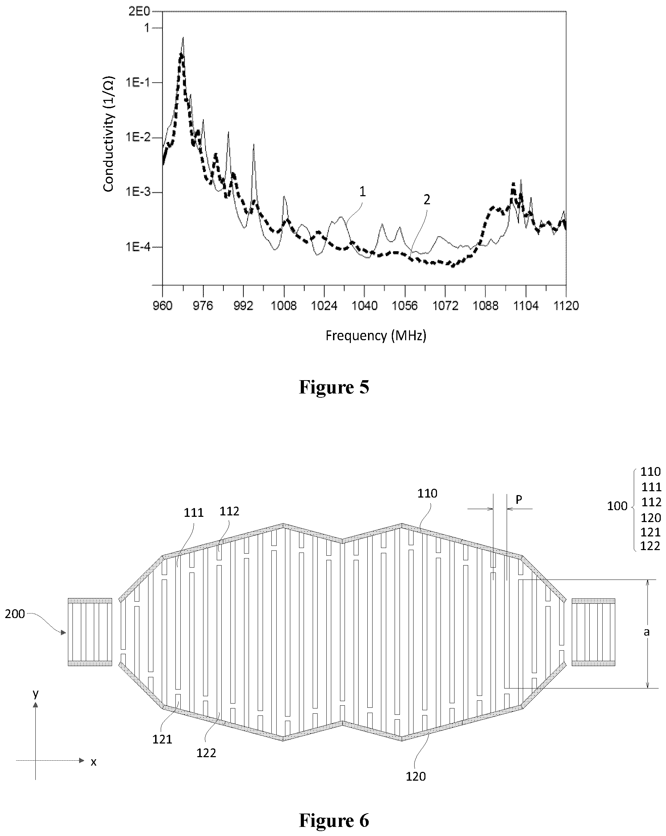

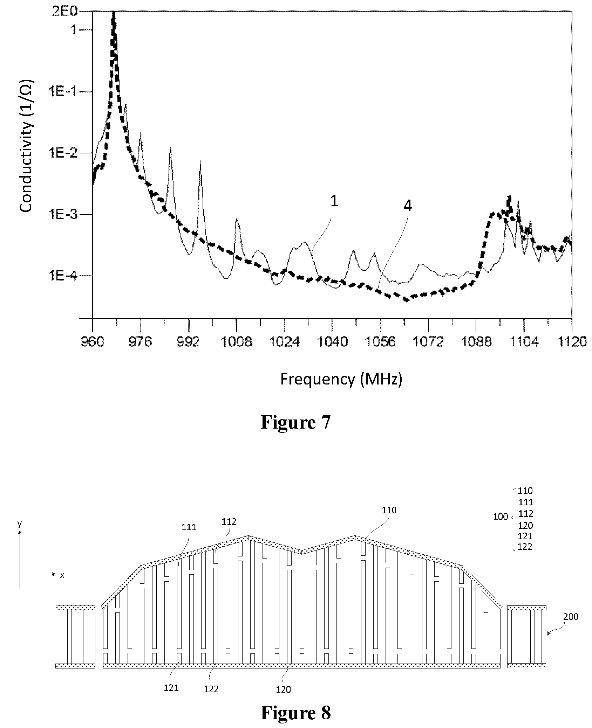

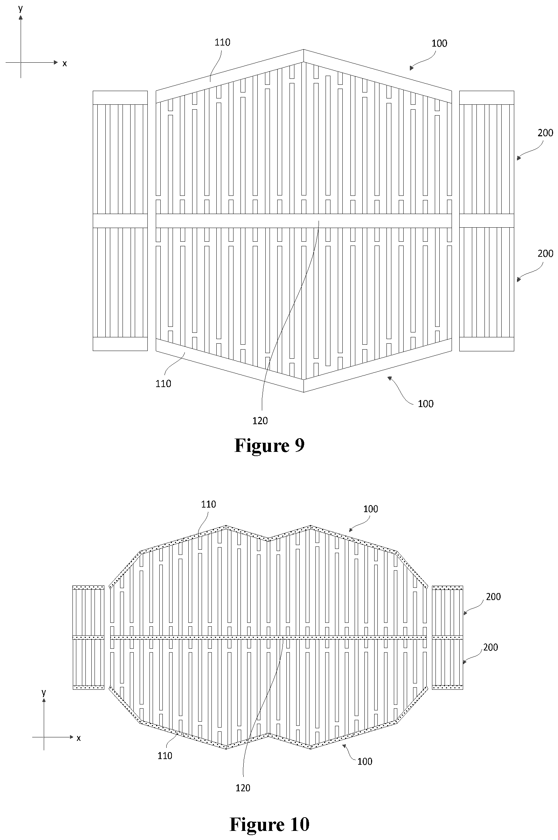

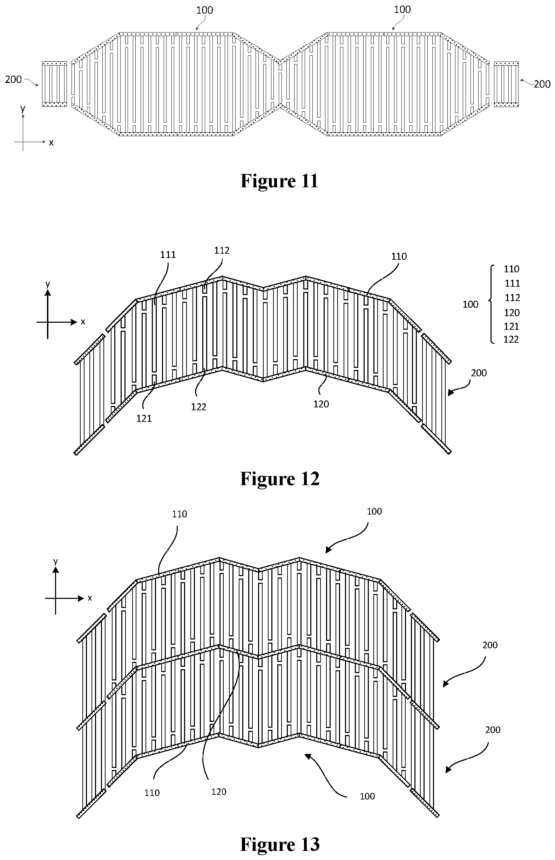

FIG. 1 is a schematic diagram of several structures of a first bus bar and a second bus bar of a surface acoustic wave resonator according to an embodiment of the present disclosure. FIG. 2 is a schematic structural diagram of a surface acoustic wave resonator according to an embodiment of the present disclosure. FIG. 3 is a graph for comparing test results of a surface acoustic wave resonator as shown in FIG. 2 and a surface acoustic wave resonator in which the transverse resonance mode is not suppressed. FIG. 4 is a schematic structural diagram of a surface acoustic wave resonator according to another embodiment of the present disclosure. FIG. 5 is a graph for comparing test results of a surface acoustic wave resonator as shown in FIG. 4 and a surface acoustic wave resonator in which the transverse resonance mode is not suppressed. FIG. 6 is a schematic structural diagram of a surface acoustic wave resonator according to another embodiment of the present disclosure. FIG. 7 is a graph for comparing test results of a surface acoustic wave resonator as shown in FIG. 6 and a surface acoustic wave resonator in which the transverse resonance mode is not suppressed. FIG. 8 is a schematic structural diagram of a surface acoustic wave resonator according to another embodiment of the present disclosure. FIG. 9 is a schematic structural diagram of a surface acoustic wave resonator comprising two cascaded interdigital electrodes according to an embodiment of the present disclosure. FIG. 10 is a schematic structural diagram of a surface acoustic wave resonator comprising two cascaded interdigital electrodes according to another embodiment of the present disclosure. FIG. 11 is a schematic structural diagram of a surface acoustic wave resonator comprising two sequentially connected interdigital electrodes according to an embodiment of the present disclosure.

Refence is made to FIGs. 2, 4, 6, 8, and 12. In embodiments of the present disclosure, the surface acoustic wave resonator comprises an interdigital electrode 100. The interdigital electrode 100 comprises a first bus bar 110, multiple first fingers 111, multiple second pseudo-fingers 112, a second bus bar 120, multiple first pseudo-fingers 121, and multiple second fingers 122. The multiple first fingers 111 and the multiple second pseudo-fingers 112 are connected to the first bus bar 110 and are alternately arranged along a first direction on the first bus bar 110. The multiple first pseudo-fingers 121 and the multiple second fingers 122 are connected to the second bus bar 120 and are alternately arranged along the first direction on the second bus bar 120. That is, the interdigital electrode 100 comprises the first bus bar 110 and the second bus bar 120, the first bus bar 110 connects the multiple first fingers 111 and the multiple second pseudo-fingers 112 which are arranged alternately along the first direction, and the second bus bar 120 connects the multiple first pseudo-fingers 121 and the multiple second fingers 122 which are arranged alternately along the first direction.

The first bus bar 110 is arranged opposite to the second bus bar 120. An end of the first bus bar 110 is aligned with an end of the second bus bar 120, and another end of the first bus bar 110 is aligned with another end of the second bus bar 120. The multiple first fingers 111 are in one-to-one correspondence to the multiple first pseudo-fingers 121. The first finger 111 and the first pseudo-finger 121, which correspond to each other, extend along the same straight line and are spaced apart by a first gap. The multiple second fingers 122 are in one-to-one correspondence to the multiple second pseudo-fingers 112. The second finger 122 and the second pseudo-finger 112, which correspond to each other, extend along the same straight line and are spaced apart by a second gap. The first finger 111 and the second pseudo-finger 112, which are adjacent to each other, are spaced apart by a gap. As shown in FIG. 6, a pitch between the first finger 111 and the second pseudo-finger 112 is P. Similarly, a pitch between the first pseudo-finger 121 and the second finger 122 is also P. The pitch between the first finger 111 and the second pseudo-finger 112 determines a resonant frequency of the surface acoustic wave resonator.

For each pair of the first finger 111 and the second finger 122 that are adjacent to each other, a distance between an end of the first finger 111 away from the first bus bar 110 and an end of the second finger 122 away from the second bus bar 120 is defined as an interdigital aperture. As shown in FIG. 6, the interdigital aperture is equal to a. Multiple such interdigital apertures are formed by the multiple first fingers 111 and the multiple second fingers 122. At least some of the multiple interdigital apertures are different from each other. The different interdigital apertures in the surface acoustic wave resonator are capable to reduce the transverse resonant modes, and hence the surface acoustic wave resonator can suppress the lateral resonant mode.

The first direction refers to a direction along which the x-axis extends. That is, the first direction is perpendicular to a lengthwise direction of the first finger 111, and the lengthwise direction of the first finger 111 is the same as a direction along which the y-axis extends.

In some embodiment, the multiple interdigital apertures formed by the adjacent pairs among the multiple first fingers 111 and the multiple second fingers 122, which are arranged alternately, follows a trend of "first increase and then decrease" along the first direction. Alternatively, the trend may be increase(s) and decrease(s) that are interleaved as an undulant form. As shown in FIG. 2, the multiple interdigital apertures formed by the adjacent pairs of the multiple first fingers 111 and the multiple second fingers 122 follows the trend of "first increase and then decrease" along the first direction. That is, the sequential multiple interdigital apertures first increase and then decrease along the first direction, such that a weighed sum of the interdigital apertures can be implemented. The weighed sum of the interdigital apertures of the surface acoustic wave resonator can reduce the transverse resonance modes, that is, suppress resonance of transverse modes. As shown in FIG. 4, the multiple interdigital apertures follow the trend of "first increase and then decrease" along the first direction. Here the trend of "first increase and then decrease" includes a case in which the multiple interdigital apertures first increase, then keep constant, and then decrease, that is, includes the case as shown in FIG. 4. The structure of the surface acoustic wave resonator as shown in FIG. 4 can also reduce the transverse resonance modes, that is, suppress resonance of transverse modes. As shown in FIG. 6, the sequential multiple interdigital apertures follow a trend of "first increase, then decrease, then increase, and then decreasing", i.e., an undulant form of interleaving increases and decreases, along the first direction. Such structure also achieves the weighted sum of the interdigital aperture, and the weighed sum of the interdigital apertures of the surface acoustic wave resonator can reduce the transverse resonance modes, that is, suppress resonance of transverse modes. As shown in FIG. 8, the sequential multiple interdigital apertures also follow the undulant form of interleaving increases and decreases along the first direction.

In an embodiment, the interdigital apertures in the surface acoustic wave resonator are modulated through a fractal design of one or both of the first bus bar 110 and the second bus bar 120. That is, a shape of at least one of the first bus bar 110 or the second bus bar 120 adopts the fractal design, such that the sequential multiple interdigital apertures follow the trend of "first increase and then decrease" or the undulant form of interleaving increases and decreases along the first direction.

The fractal design on the one or both of the first bus bar 110 and the second bus bar 120 may be as follows. Reference is made to FIG. 1. At least one of the first bus bar 110 or the second bus bar 120 has a shape of an n^{th} fractal iteration, and the n^{th} fractal iteration comprises 2ⁿ⁻¹ similar figures of a 1^{st} fractal iteration 113 that are sequentially connected. The similar figure of the first fractal iteration 113 comprises a first connecting bar 1131 and a second connecting bar 1132 connected to each other, and a line connecting an end of the first connecting bar 1131 away from the second connecting bar 1132 and an end of the second connecting bar 1132 away from the first connecting bar 1131 is located between the first bus bar 110 and the second bus bar 120. That is, an included region between the first connecting bar 1131 and the second connecting bar 1132 opens toward a space between the first bus bar 110 and the second bus bar 120. An angle between the first connecting bar 1131 and a first straight line 1133 is defined as a first deflection angle θ₁, and an angle between the second connecting bar 1132 and the first straight line 1133 is defined as a second deflection angle θ₂. The first straight line 1133 is perpendicular to the first finger 111. Both the first deflection angle and the second deflection angle are acute angles. That is, the first straight line 1133 is parallel to the direction along which the x-axis extends. The 2ⁿ⁻¹ similar figures of the 1^{st} fractal iterations 113 in the n^{th} fractal iteration form 2ⁿ⁻¹ respective first deflection angles and 2ⁿ⁻¹ respective second deflection angles. That is, each similar figure of the 1^{st} fractal iteration has one first deflection angle and one second deflection angle, and the 2ⁿ⁻¹ first fractal iterations 113 have the 2ⁿ⁻¹ first deflection angles and the 2ⁿ⁻¹ second deflection angles. At least a part of the 2ⁿ⁻¹ first deflection angles each ranges from 2° to 16°, and at least a part of the 2ⁿ⁻¹ second deflection angles each ranges from 2° to 16°. The first deflection angle(s) ranging from 2° to 16° and the second deflection angle(s) ranging from 2° to 16° can deflect a propagation direction of acoustic waves in the surface acoustic wave resonator toward the direction along which the first fingers 111 are arranged. Hence, the propagation direction of the acoustic waves in the surface acoustic wave resonator tends to follow the arrangement direction of the first fingers 111. The propagation direction of the acoustic waves approximating the arrangement direction of the first fingers 111 facilitates reducing the transverse component of the acoustic waves. Moreover, the fractal design on the first bus bar 110 and/or the second bus bar 120 can modulate the interdigital apertures of the surface acoustic wave resonator, which further reduces the transverse resonance modes. Hence, the transverse resonance modes are suppressed in the surface acoustic wave resonator.

The direction along which the first fingers 111 are arranged is identical to the x- axis direction.

The fractal design on the first bus bar 110 and/or the second bus bar 120 can not only provide the first deflection angles ranging from 2° to 16° and the second deflection angles ranging from of 2° to 16° for reducing and suppressing generation of the transverse component of the acoustic waves, but also modulate the interdigital apertures of the surface acoustic wave resonator for suppressing resonance of transverse modes and reducing the transverse resonance modes. Hence, the surface acoustic wave resonator provided herein can better suppress the transverse resonance modes in two manners and achieves a better effect.

Reference is made to FIG. 2, where each of the first bus bar 110 and the second bus bar 120 of the surface acoustic wave resonator has a shape of the 1^{st} fractal iteration 113. Such shape has one first deflection angle ranging from 2° to 16° and one second deflection angle ranging from 2° to 16°. The sequential multiple interdigital apertures follow a trend of "first increase and then decrease" along the first direction. The surface acoustic wave resonator as shown in FIG. 2 was tested and compared with a surface acoustic wave resonator in which the transverse resonance modes are not suppressed. A result of the comparison is as shown in FIG. 3. In FIG. 3, solid line 1 indicates the case in which the transverse resonance modes are not suppressed, and dotted line 3 indicates the case of the surface acoustic wave resonator as shown in FIG. 2. There are undulating peaks in solid line 1, and the undulating peaks indicating existence of the transverse resonance modes. It can be seen from FIG. 3 that the surface acoustic wave resonator as shown in FIG. 2 can suppress the resonance of the transverse modes well and reduce the transverse resonance modes, which achieves the effect of suppressing the transverse resonance modes in the surface acoustic wave resonator.

Reference is made to FIG. 4, where each of the first bus bar 110 and the second bus bar 120 of the surface acoustic wave resonator has a shape of the 2^{nd} fractal iteration 114. Such shape has two first deflection angles and two second deflection angles. One first deflection angle ranges from 2° to 16°, the other first deflection angle is equal to 0°. One second deflection angle ranges from 2° to 16°, the other second deflection angle is equal to 0°. The sequential multiple interdigital apertures follow a trend of "first increase, then constant, and then decrease" along the first direction. The surface acoustic wave resonator as shown in FIG. 4 was tested and compared with a surface acoustic wave resonator in which the transverse resonance modes are not suppressed. A result of the comparison is as shown in FIG. 5. In FIG. 5, solid line 1 indicates the case in which the transverse resonance modes are not suppressed, and dotted line 2 indicates the case of the surface acoustic wave resonator as shown in FIG. 4. There are undulating peaks in solid line 1, and the undulating peaks indicating existence of the transverse resonance modes. It can be seen from FIG. 5 that the surface acoustic wave resonator as shown in FIG. 4 can also suppress the resonance of the transverse modes well and reduce the transverse resonance modes, which achieves the effect of suppressing the transverse resonance modes in the surface acoustic wave resonator.

In some embodiments, each of the first bus bar 110 and the second bus bar 120 of the surface acoustic wave resonator has the shape of the 2^{nd} fractal iteration 114. Such shape has two first deflection angles and two second deflection angles, the two first deflection angles range from 2° to 16°, and the two second deflection angles range from 2° to 16°. In such case, there are no "constant" part of the interdigital apertures in the middle portion. The resonance of the transverse modes can be better suppressed and the transverse resonance mode can be better reduced in comparison with the surface acoustic wave resonator as shown in FIG. 4.

Reference is made to FIG. 6, where each of the first bus bar 110 and the second bus bar 120 of the surface acoustic wave resonator shown has a shape of the 3^{rd} fractal iteration 115. Such shape has four first deflection angles and four second deflection angles, the four first deflection angles range from 2° to 16°, and the four second deflection angles range from 2° to 16°. The sequential multiple interdigital apertures follow a trend of "first increase, then decrease, then increase, and then decrease" along the first direction, that is, an undulant form of interleaving increases and decreases along the first direction. The surface acoustic wave resonator as shown in FIG. 6 was tested and compared with a surface acoustic wave resonator in which the transverse resonance modes are not suppressed. A result of the comparison is as shown in FIG. 7. In FIG. 7, solid line 1 indicates the case in which the transverse resonance modes are not suppressed, and dotted line 4 indicates the case of the surface acoustic wave resonator as shown in FIG. 6. There are undulating peaks in solid line 1, and the undulating peaks indicating existence of the transverse resonance modes. It can be seen from FIG. 7 that the surface acoustic wave resonator as shown in FIG. 6 can also suppress the resonance of the transverse modes well and reduce the transverse resonance modes, which achieves the effect of suppressing the transverse resonance modes in the surface acoustic wave resonator.

In some embodiments, one of the first bus bar 110 and the second bus bar 120 has a shape of an n^{th} fractal iteration, and the other has a shape of a straight bar. As shown in FIG. 8, the first bus bar 110 has the shape of the 3^{rd} fractal iteration 115, and the second bus bar 120 has the shape of a straight bar. It is appreciated that the first bus bar 110 may alternatively have the shape of the 1^{st} fractal iteration 113, the 2^{nd} fractal iteration 114, or the like. Such shape also has multiple first deflection angles ranging from 2° to 16° and multiple second deflection angles ranging from 2° to 16°. The sequential multiple interdigital apertures follow a trend of "first increase, then decrease, then increase, and then decrease" along the first direction, that is, an undulant form of interleaving increases and decreases. Such structure can also suppress the resonance of the transverse modes well and reduce the transverse resonance modes, which achieves the effect of suppressing the transverse resonance modes in the surface acoustic wave resonator. In addition, configuration one of the first bus bar 110 and the second bus bar 120 as the straight bar facilitates cascading of two interdigital electrodes 100. As an example, the first bus bar 110 has the shape of the n^{th} fractal iteration, the second bus bar 120 has the shape of the straight bar, the surface acoustic wave resonator comprises two such interdigital electrodes 100 that are cascaded. The two interdigital electrodes 100 share the second bus bar 120, while each interdigital electrodes 100 comprises the respective first bus bar 11. The first bus bars 110 of the two interdigital electrodes 100 are located at two sides, respectively, of the second bus bar 120. In other words, the first bus bars 110 of the two interdigital electrodes 100 are located at two ends, respectively, of the surface acoustic wave resonator along the lengthwise direction of the first finger 111. The first bus bars 110 of the two interdigital electrodes 100 are arranged opposite to each other, and the two interdigital electrodes 100 share the same second bus bar 120.

In some embodiments, each of the first bus bar and the second bus bar has the shape of the n^{th} fractal iteration, and multiple connecting bars of the first bus bar are arranged parallel to straight bars, respectively, of the second bus bar. Reference is made to FIG. 12, where each of the first bus bar 110 and the second bus bar 120 has the shape of the 3^{rd} fractal iteration 115. Each of the first bus bar 110 and the second bus bar 120 comprises eight connecting bars, and the eight connecting bars of the first bus bar 110 are parallel to the eight connecting bars of the second bus bar 120 sequentially from left to right. Such shape also has multiple first deflection angles ranging from 2° to 16° and multiple second deflection angles ranging from 2° to 16°. The sequential multiple interdigital apertures follow an undulant form of interleaving increases and decreases. Similarly, each of the first bus bar 110 and the second bus bar 120 can alternatively have the shape of the 1^{st} fractal iteration 113, the 2^{nd} fractal iteration 114, or the like. Such structure in which each of the first bus bar 110 and the second bus bar 120 has the shape of the n^{th} fractal iteration also facilitates the cascading of the two interdigital electrodes 100. As shown in FIG. 13, the surface acoustic wave resonator comprises two such interdigital electrodes 100 that are cascaded. The two interdigital electrodes 100 share the second bus bar 120, while each of the two interdigital electrodes 100 comprises a respective first bus bar 110. The first bus bars 110 of the two interdigital electrodes 100 are located at two sides, respectively, of the second bus bar 120. In other words, the first bus bars 110 of the two interdigital electrodes 100 are located at two ends, respectively, of the surface acoustic wave resonator along the lengthwise direction of the first finger 111. The first bus bars 110 of the two interdigital electrodes 100 are arranged opposite to each other, the two interdigital electrodes 100 share the same second bus bar 120, and the multiple connecting bars of the first bus bar 110 are parallel to those of the second bus bar 120. Such structure can also suppress the resonance of the transverse modes well and reduce the transverse resonance modes, which achieves the effect of suppressing the transverse resonance modes in the surface acoustic wave resonator.

Reference is made to FIG. 9. In some embodiments, the first bus bar 110 has a shape of the 1^{st} fractal iteration 113, and the second bus bar 120 has a shape of the straight bar. The surface acoustic wave resonator comprises two such interdigital electrodes 100 that are cascaded, the two interdigital electrodes 100 share the second bus bar 120 while each interdigital electrode 100 comprises a respective first bus bar 110, and the first bus bars 110 of the two interdigital electrodes 100 are located at two sides, respectively, of the second bus bar 120. Reference is made to FIG. 10. In some embodiments, the first bus bar 110 has a shape of a 3^{rd} fractal iteration 115 and the second bus bar 120 has a shape of the straight bar. The surface acoustic wave resonator comprises two such interdigital electrodes 100 that are cascaded, the two interdigital electrodes 100 share the second bus bar 120 while each interdigital electrode 100 comprises a respective first bus bar 110, and the first bus bars 110 of the two interdigital electrodes 100 are located at two sides, respectively, of the second bus bar 120.

In some embodiments, each of the first bus bar 110 and the second bus bar 120 has a shape of the n^{th} fractal iteration, and the first bus bar 110 and the second bus bar 120 are symmetrical with respect to a first center line. The first center line is perpendicular to the lengthwise direction of the first finger 111 and passes a center of the interdigital electrode 100. Such structure renders a shape of the surface acoustic wave resonator more regular.

In some embodiments, lengths of the first pseudo-fingers 121 are identical, lengths of at least a part of the first fingers 111 are different, lengths of the second pseudo-fingers 112 are identical, and lengths of at least a part of the second fingers 112 are different. In other words, the interdigital apertures are altered through adjusting the lengths of the first finger 111 and the second finger 122, and a size of the first gap and a size of the second gap each is kept constant.

In an embodiment, the surface acoustic wave resonator further comprises two reflective gratings 200, which are arranged at two sides, respectively, of the interdigital electrode 100 along a direction perpendicular to the lengthwise direction of the first finger 111 (i.e., along the x-axis direction) or along a direction along which the first bus bar 110 extends. Each of the two reflective gratings 200 is spaced apart from the interdigital electrode 100. The two reflective gratings 200 are configured to reflect acoustic wave signals, which are leaked into the two sides of the interdigital electrode 100, back to the interdigital electrode 100.

In an optional embodiment, the reflective grating 200 comprises a third bus bar and a fourth bus bar that are arranged opposite to each other and further comprise a grid electrode arranged between the third bus bar and the fourth bus bar.

In some embodiments, there are multiple such interdigital electrodes 100, and the multiple interdigital electrodes 100 are sequentially arranged along the direction perpendicular to the lengthwise direction of the first finger 111 (i.e., along the x-axis direction). The two reflective gratings 200 are arranged two sides, respectively, of the multiple interdigital electrodes 100 along the direction perpendicular to the lengthwise direction of the first finger 111 (i.e., along the x-axis direction). Each of the two reflective gratings 200 is spaced apart from the multiple interdigital electrodes 100. Reference is made to FIG. 11 for an example, in which there are two interdigital electrodes 100. The two interdigital electrodes 100 are sequentially connected, the two reflective gratings 200 are arranged at two sides of the two connected interdigital electrodes 100 along the direction perpendicular to the lengthwise direction of the first finger 11, and each reflective grating 200 is spaced apart from the two connected interdigital electrodes 100.

A surface acoustic wave filter is further provided according to an embodiment of the present disclosure. The surface acoustic wave filter comprises a supporting substrate, a temperature compensation layer, and a piezoelectric substrate, which are stacked sequentially. The surface acoustic wave filter further comprises a surface acoustic wave resonator arranged on the piezoelectric substrate. That is, the surface acoustic wave filter comprises the supporting substrate, the temperature compensation layer, the piezoelectric substrate, and the surface acoustic wave resonator arranged on the piezoelectric substrate. The surface acoustic wave resonator is the surface acoustic wave resonator according to any foregoing embodiment. The piezoelectric substrate comprises a material having a piezoelectric effect, and a temperature coefficient of the temperature compensation layer is opposite to that of the piezoelectric substrate. In an embodiment, the piezoelectric substrate is a lithium tantalate substrate.

Those skilled in the art would conceive other embodiments of the present disclosure easily after reading this specification and practicing the solutions disclosed herein. The present disclosure is intended for covering any modification, utilization, or adaptive modification of the embodiments, where the modification, utilization, or adaptive modification follows a general principle of the present disclosure and may utilize common knowledge or common techniques in the art that are not disclosed herein. The specification and embodiments are exemplary only, and an actual scope and a spirit of the present disclosure are defined by the claims.

It should be understood that the present disclosure is not limited to precise structures that have been described above and shown in the drawings. Various modifications and changes may be made without departing from a scope there of these structures. The scope of the present disclosure is only subject to the appended claims.

## Claims

1. A surface acoustic wave resonator, comprising an interdigital electrode, wherein:
the interdigital electrode comprises a first bus bar and a second bus bar that are opposite to each other;
the first bus bar connects a plurality of first fingers and a plurality of second pseudo-fingers, and first fingers of the plurality of first fingers and second pseudo-fingers of the plurality of second pseudo-fingers are alternately arranged along a first direction;
the second bus bar connects a plurality of second fingers and a plurality of first pseudo-fingers, and second fingers of the plurality of second fingers and first pseudo-fingers of the plurality of first pseudo-fingers are alternately arranged along the first direction;
the first fingers are in one-to-one correspondence with the first pseudo-fingers;
for each first finger of the plurality of first fingers, a straight line along which said first finger extends is identical to a straight line along which a first pseudo-finger corresponding to said first finger among the plurality of first pseudo-fingers extends, and said first finger and the first pseudo-finger are spaced apart by a first gap;
the second fingers are in one-to-one correspondence with the second pseudo-fingers;
for each second finger of the plurality of second fingers, a straight line along which said second finger extends is identical to a straight line along which a second pseudo-finger corresponding to said second finger among the plurality of second pseudo-fingers extends, and said second finger and the second pseudo-finger are spaced apart by a second gap;
for every pair of a first finger of the plurality of first fingers and a second finger of the plurality of second fingers, which are adjacent to each other, a distance between an end of the first finger away from the first bus bar and an end of the second finger away from the second bus bar serves as a respective interdigital aperture of a plurality of interdigital apertures;
the plurality of interdigital apertures is formed among the plurality of first fingers and the plurality of second fingers; and
at least a part of the plurality of interdigital apertures comprises different interdigital apertures.

2. The surface acoustic wave resonator according to claim 1, wherein:
the first direction is perpendicular to a lengthwise direction of the first fingers; and
along the first direction, interdigital apertures of the plurality of interdigital apertures formed among the first fingers and the second fingers that are alternately arranged are subject to:
an increase and then a decrease, or
one or more increases and one or more decreases that are interleaved.

3. The surface acoustic wave resonator according to claim 2, wherein:
at least one of the first bus bar and the second bus bar has a shape of n-th fractal iteration, wherein the n-th fractal iteration comprises 2ⁿ⁻¹ similar figures of a first fractal iteration that are sequentially connected, wherein n is a positive integer.
each of the similar figures of the first fractal iteration comprises a first connecting bar and a second connecting bar that are connected to each other, wherein a line connecting an end of the first connecting bar away from the second connecting bar and an end of the second connecting bar away from the first connecting bar is located between the first bus bar and the second bus bar;
an acute angle between the first connecting bar and a first straight line serves as a first deflection angle, an acute angle between the second connecting bar and the first straight line serves as a second deflection angle, and the first straight line is perpendicular to the lengthwise direction of the first fingers; and
at least a part of the 2ⁿ⁻¹ first deflection angles of the 2ⁿ⁻¹ similar figures of the first fractal iterations ranges from 2° to 16°, and at least a part of the 2ⁿ⁻¹ second deflection angles of the 2ⁿ⁻¹ similar figures of the first fractal iterations ranges from 2° to 16°.

4. The surface acoustic wave resonator according to claim 3, wherein one of the first bus bar and the second bus bar has the shape of the n-th fractal iteration, and another of the first bus bar and the second bus bar is a straight bar.

5. The surface acoustic wave resonator according to claim 4, wherein:
the first bus bar has the shape of the n-th fractal iteration, and the second bus bar is the straight bar; and
the surface acoustic wave resonator comprises another interdigital electrode identical to the interdigital electrode in structure, wherein the another interdigital electrode and the interdigital electrode share the second bus bar, and the first bus bar of the interdigital electrode and the first bus bar of the another interdigital electrode are located at two sides, respectively, of the second bus bar.

6. The surface acoustic wave resonator according to claim 3, wherein:
each of the first bus bar and the second bus bar has the shape of the n-th fractal iteration;
the first bus bar and the second bus bar are symmetrical with respect to a first center line; and
the first center line is perpendicular to the lengthwise direction of the first fingers and passes a center of the interdigital electrode.

7. The surface acoustic wave resonator according to claim 3, wherein:
each of the first bus bar and the second bus bar has the shape of the n-th fractal iteration, and
connecting bars of the first bus bar are parallel to connecting bars, respectively, of the second bus bar.

8. The surface acoustic wave resonator according to claim 1, wherein:
a length of the first pseudo-finger corresponding to each first finger is identical, and lengths of first fingers in at least a part of the plurality of first fingers are different; and
a length of the second pseudo-finger corresponding to each second finger is identical, and lengths of second fingers in at least a part of the plurality of second fingers are different.

9. The surface acoustic wave resonator according to claim 1, wherein:
the surface acoustic wave resonator further comprises two reflective gratings, which are arranged at two sides, respectively, of the interdigital electrode along a direction perpendicular to a lengthwise direction of the first fingers;
each of the two reflective gratings is spaced apart from the interdigital electrode; and
the two reflective gratings are configured to reflect acoustic wave signals, which are leaked into the two sides of the interdigital electrode, back to the interdigital electrode.

10. The surface acoustic wave resonator according to claim 9, wherein:
the surface acoustic wave resonator comprises a plurality of interdigital electrodes, which comprises the interdigital electrode and one or more other interdigital electrodes, each of which is identical to the interdigital electrode in structure;
the interdigital electrode and the one or more other interdigital electrodes are sequentially arranged along the direction perpendicular to the lengthwise direction of the first fingers;
the two reflective gratings are arranged at two sides, respectively, of the plurality of interdigital electrodes along the direction perpendicular to the lengthwise direction of the first fingers; and
each of the two reflective gratings is spaced apart from the plurality of interdigital electrodes.

11. A surface acoustic wave filter, comprising:
a supporting substrate, a temperature compensation layer, and a piezoelectric substrate, which are stacked in the above-listed sequence; and
the surface acoustic wave resonator according to any one of claims 1 to 10.
